# EUROPÄISCHE PATENTSCHRIFT

(11) **EP 3 680 550 B1**
(45) Veröffentlichungstag und Bekanntmachung des Hinweises auf die Patenterteilung: **09.03.2022**
(21) Anmeldenummer: 20150878.5
(22) Anmeldetag: 09.01.2020
(51) Int. Cl.: F21V 23/00, F21V 23/06, F21V 21/002, H05K 1/18, F21S 8/04, F21S 9/02, F21V 21/005, F21Y 115/10

(54) **LEUCHTENANORDNUNG FÜR EINE LÄNGLICHE LEUCHTE**
LIGHT ARRANGEMENT FOR AN ELONGATED LAMP
AGENCEMENT D'ÉCLAIRAGE POUR UN LUMINAIRE LONG

(30) Priorität: 11.01.2019 DE 202019100126 U
(43) Veröffentlichungstag der Anmeldung: 15.07.2020
(73) Patentinhaber: Zumtobel Lighting GmbH, 6850 Dornbirn (AT)
(72) Erfinder: Mayr, Gregor, 6974 Gaißau (AT)
(74) Vertreter: Kiwit, Benedikt

(56) Entgegenhaltungen:
- WO-A1-2010/053250
- WO-A1-2018/109080
- JP-A- 2004 207 043
- KR-A- 20140 122 474
- US-A1- 2014 063 793

## Beschreibung

### 1. Gebiet der Erfindung

Die vorliegende Erfindung betrifft eine längliche Leuchte aufweisend eine Leuchtenanordnung.

### 2. Hintergrund

Leuchtenanordnungen der eingangs genannten Art sind prinzipiell aus dem Stand der Technik bekannt. Diese kommen beispielsweise als Notleuchte oder Sicherheitsleuchte in einer länglichen Leuchte zum Einsatz. Zur mechanischen Befestigung der Leuchtenanordnung an der Leuchte kommt in der Regel eine Befestigungsvorrichtung (auch bekannt als TECTON-System) zum Einsatz, mit welcher mittels eines Drehknebels die Leuchtenanordnung an einer Leuchtentragschiene der Leuchte durch einfaches Einklicken bzw. Einrasten einfach installiert werden kann; dies hat den Vorteil der Flexibilität, da die Leuchtenanordnung an einer beliebigen Stelle der Leuchte bzw. Leuchtentragschiene positioniert und bezüglich dieser verschoben werden kann.

Zur Versorgung der Leuchtenanordnung bzw. eines Leuchtmittels der Leuchtenanordnung ist es bekannt, ein Betriebsgerät zu verwenden, welches mit einer Spannung von 230 V versorgt wird. Dadurch, dass das Betriebsgerät mit einer verhältnismäßig hohen Spannung betrieben wird, muss dieses wegen entsprechender Komponenten (AC/DC-Wandler etc.) insgesamt recht groß ausgeführt werden. Aus diesem Grund muss auch die Leuchtenanordnung insgesamt sehr lang ausgebildet werden, was dazu führt, dass es in der Leuchte zu vergleichsweise großen Dunkelstellen zwischen der Leuchtenanordnung und zu der Leuchtenanordnung benachbarten Leuchtelementen, beispielsweise einer weitere Leuchtenanordnung und/oder einem Lichtbalken, kommt. Dies wirkt sich wiederum nachteilig auf die Lichtabgabe bzw. das Erscheinungs- bzw. Deckenbild der Leuchtenanordnung und somit der Leuchte insgesamt aus. Auch der Energiespeicher bzw. Akku der Leuchtenanordnung sowie der für die mechanische Befestigung notwendige Drehknebel erfordern verhältnismäßig viel Bauraum, was die Bildung der ungewünschten Dunkelstelle begünstigt.

Die JP 2004 - 207 043 A zeigt eine Lampe für eine Lichterkette, in der auf einer Leiterplatine an einer Stirnseite eine RGB-LED Anordnung vorgesehen ist. Die Leiterplatte ist in der Lampe von einem unteren Sockel und einem oberen Glaskolben umschlossen.

Die US 2014/063793 A1 zeigt eine Leuchte mit einem U-förmigen Rahmen in einem abgedichteten zylindrischen Gehäuse. Entlang der Mitte der Vorderseite des Rahmens sind eine oder mehrere LED-Lampentafeln montiert, die eine Reihe von LEDs umfassen, von denen einige von einer Reservequelle wie einer optional gelieferten Batterie für die Notausgangsbeleuchtung gespeist werden können. An jeder Seite der LED-Lampenpaneele ist ein hochglanzpolierter Reflektor am Rahmen angebracht, um das Licht zu fokussieren und zu bündeln und gleichzeitig die LEDs vor der vom Rahmen abgestrahlten Wärme abzuschirmen.

Die WO 2018/109080 A1 zeigt eine LED-Leuchte mit einem länglichen Gehäuse mit einer transparenten Wand zur Lichtemission sowie LEDs auf einem Substrat. Endkappen sind an den gegenüberliegenden Enden des Gehäuses vorgesehen. Die Endkappen weisen ein Endkappengehäuse auf, welches mit einem Ende des länglichen Gehäuses in Eingriff steht, und eine am Endkappengehäuse gelenkig gelagerte Abdeckung aufweist, die den Zugang zum Innenraum des Endkappengehäuses ermöglicht und den Innenraum dicht abschließen kann. Die Endkappe kann eine Notlichtlampe aufweisen.

Ausgehend von diesem Stand der Technik stellt sich die vorliegende Erfindung die Aufgabe, eine längliche Leuchte mit einer Leuchtenanordnung bereitzustellen, mit welcher Dunkelstellen vermieden werden oder zumindest reduziert sind und welche kompakter ausgebildet ist.

Diese und andere Aufgaben, die beim Lesen der folgenden Beschreibung noch genannt werden oder vom Fachmann erkannt werden können, werden mit dem Gegenstand des unabhängigen Anspruchs gelöst.

### 3. Ausführliche Beschreibung der Erfindung

Die Erfindung betrifft eine längliche Leuchte mit einer Längsachse. Die Leuchte weist ein Primärleuchtmittel zur Abstrahlung von Licht sowie eine Leuchtenanordnung auf.

Die Leuchtenanordnung weist auf: ein Leuchtmittel zur Abstrahlung von Licht, und ein Niedervolt-Betriebsgerät zur Versorgung des Leuchtmittels mit einer Versorgungsspannung. Das Betriebsgerät weist eine Platine auf, wobei die Platine zwei flächige, sich im Wesentlichen parallel zu einer Erstreckungsebene der Platine erstreckende Seiten und eine die zwei flächigen Seiten verbindende umlaufende Stirnseite aufweist. Die Erstreckungsebene der Platine der Leuchtenanordnung ist im Wesentlichen senkrecht zur Längsachse der Leuchte. Das Leuchtmittel ist auf Seiten der Stirnseite der Platine angeordnet. Das Leuchtmittel der Leuchtenanordnung ist ein Sekundärleuchtmittel der länglichen Leuchte.

"Auf Seiten der Stirnseite" wird erfindungsgemäß insbesondere derart verstanden, dass das Leuchtmittel der Stirnseite direkt oder schräg gegenüberliegend angeordnet ist und/oder auf der Stirnseite angeordnet ist.

Dadurch, dass das Betriebsgerät also nicht ein mit einer hohen Spannung gespeistes Betriebsgerät ist, erfordert das Betriebsgerät weniger elektronische Komponenten bzw. Peripherieelemente (AC/DC Wandler etc.). Das Betriebsgerät kann somit deutlich kompakter ausgeführt werden, wodurch die Platine in der Leuchtenanordnung so angeordnet werden kann, dass die Hauptabstrahlrichtung des Leuchtmittels im Wesentlichen parallel zur Erstreckungsebene der Platine ist. Die Leuchtenanordnung kann somit bei Blick parallel zur Erstreckungsebene bzw. zur Hauptabstrahlrichtung des Leuchtmittels weniger breit ausgeführt werden. Die Dunkelstelle der Leuchtenanordnung ist somit reduziert, da diese sich im Wesentlichen lediglich durch die Breite bzw. Dicke der verhältnismäßig dünnen Platine definiert.

Da die Erstreckungsebene der Platine der Leuchtenanordnung im Wesentlichen senkrecht zur Längsachse der Leuchte ist, kann die Leuchtenanordnung in der Leuchte besonders platzsparend, insbesondere in einem Aufnahmeraum der Leuchtentragschiene der Leuchte, und mit einer besonders schmalen bzw. kaum vorhandenen Dunkelstelle vorgesehen werden.

Das von dem Primärleuchtmittel abgestrahlte Licht kann beispielsweise zur Allgemeinbeleuchtung, insbesondere zur Ausleuchtung eines Gangs und/oder Raums, dienen. Das Sekundärleuchtmittel dient beispielsweise als Notleuchte, um einen Fluchtweg anzuzeigen. Durch die kompakte und insbesondere kaum vorhandene Dunkelstelle der Leuchtenanordnung ergibt sich somit ein besonders vorteilhaftes Erscheinungsbild der Leuchte. Bevorzugt ist, wenn die Lichtabstrahlebene des Leuchtmittels bzw. des optischen Elements der Leuchtenanordnung in der Lichtabstrahlebene der Leuchte angeordnet ist.

Die Platine weist vorzugsweise eine in der Erstreckungsebene angeordnete elektrische Kontaktierungsanordnung zum elektrischen Abgriff (von elektrischer Energie, also Strom und/oder Spannung) für die Leuchtenanordnung und/oder zur mechanischen Halterung der Leuchtenanordnung auf. Da die elektrische Kontaktierungsanordnung in der Erstreckungsebene angeordnet ist, kann die Leuchtenanordnung selbst mit der elektrischen Kontaktierungsanordnung bezüglich der Breite kompakt ausgeführt werden, sodass durch die elektrische Kontaktierungsanordnung keine ungewünschte Dunkelstelle der Leuchtenanordnung verursacht wird. Ferner bleibt durch die Anordnung der elektrischen Kontaktierungsanordnung in der Erstreckungsebene der Platine eine gute Zugänglichkeit zur elektrischen Kontaktierung und/oder zur mechanischen Halterung der Leuchtenanordnung gewährleistet. Somit kann die Leuchtenanordnung beispielsweise einfach in eine Leuchtentragschiene durch Drehung und/oder Einstecken elektrisch und/oder mechanisch kontaktiert werden. Zusätzliche Montagevorrichtungen, beispielsweise der aus dem Stand der Technik bekannte Drehknebel, können somit entfallen, wodurch die Leuchtenanordnung insbesondere hinsichtlich der Baulänge wesentlich kompakter ausgeführt werden kann (beispielsweise Reduzierung der Baulänge von einem halben Meter auf ein paar Zentimeter).

Die elektrische Kontaktierungsanordnung kann mit einer Leuchtentragschiene der länglichen Leuchte verbindbar sein, um von der Leuchtentragschiene für den elektrischen Abgriff elektrische Energie abzugreifen und/oder um die Leuchtenanordnung an der Leuchtentragschiene mechanisch zu halten. Das heißt, die Leuchtenanordnung kann in einer Richtung senkrecht bzw. hochkant zur Längsachse der Leuchtentragschiene, also beispielsweise von unten, in die Leuchtentragschiene eingesteckt werden. Alternativ oder zusätzlich kann somit die Leuchtenanordnung auch seitlich in die Leuchtentragschiene, also in einer Richtung parallel zur Längsachse, in die Leuchtentragschiene eingebracht werden, beispielsweise indem die elektrische Kontaktierungsanordnung in der Leuchtentragschiene zunächst so positioniert wird, dass diese die Leuchtentragschiene elektrisch und/oder mechanisch kontaktiert, und anschließend die Leuchtenanordnung so gedreht wird, dass diese ihre bestimmungsgemäße Stellung in der Leuchtentragschiene einnimmt.

Vorzugsweise weist die Stirnseite die elektrische Kontaktierungsanordnung auf. Folglich wird eine besonders gute Zugänglichkeit der elektrischen Kontaktierungsanordnung gewährleistet, während die Leuchtenanordnung insbesondere hinsichtlich der Breite kompakt ausgeführt ist. Vorzugsweise weist eine dem Leuchtmittel abgewandte Seite der Stirnseite, beispielsweise eine Rückseite der Stirnseite, die elektrische Kontaktierungsanordnung auf. Mit anderen Worten ist die elektrische Kontaktierungsanordnung somit bei Blick auf die das Leuchtmittel aufweisende Seite der Stirnseite, also eine Vorderseite der Stirnseite, hinter der Platine angeordnet, wodurch die Leuchtenanordnung insbesondere hinsichtlich ihrer Höhe und Breite kompakt ausgeführt werden kann.

Die elektrische Kontaktierungsanordnung kann ein elastisches Element, vorzugsweise eine Feder, besonders bevorzugt eine Spiral-und/oder Schraubenfeder, aufweisen, welches derart angeordnet ist, dass eine Rückstellkraft des elastischen Elements den elektrischen Abgriff und/oder die mechanische Halterung der Leuchtenanordnung unterstützt. Durch die mittels der Rückstellkraft des vorgespannten elastischen Elements bewirkte kraftschlüssige Verbindung kann somit ein stets zuverlässiger elektrischer Abgriff bzw. eine stets zuverlässige mechanische Halterung gewährleistet werden. Beispielsweise kann das elastische Element somit fertigungsbedingte Toleranzen der Leuchtentragschiene gut ausgleichen.

Die elektrische Kontaktierungsanordnung weist vorzugsweise wenigstens ein elektrisches Kontaktierungselement zur elektrischen Kontaktierung für den elektrischen Abgriff und/oder zur mechanischen Halterung der Leuchtenanordnung auf. Vorzugsweise ist das elastische Element so angeordnet, dass durch die Rückstellkraft des elastischen Elements das wenigstens eine elektrische Kontaktierungselement in eine Stellung zur elektrischen Kontaktierung für den elektrischen Abgriff und/oder in eine Stellung zur mechanischen Halterung der Leuchtenanordnung gedrückt wird. Das elektrische Kontaktierungselement und, falls vorhanden, das elastische Element kann/können dabei insbesondere bewirken, dass der elektrische Abgriff und/oder die mechanische Halterung der Leuchtenanordnung in einer definierten Stellung erfolgt, was folglich die Handhabung der Leuchtenanordnung zur Montage der Leuchtenanordnung verbessert.

Bevorzugt weist die elektrische Kontaktierungsanordnung wenigstens zwei elektrische Kontaktierungselemente auf, wobei das elastische Element derart angeordnet ist, dass durch die Rückstellkraft des elastischen Elements die wenigstens zwei elektrischen Kontaktierungselemente voneinander weg und in eine Stellung zur elektrischen Kontaktierung für den elektrischen Abgriff und/oder in eine Stellung zur mechanischen Halterung gedrückt werden. Somit wird die Rückstellkraft des elastischen Elements gleichmäßig auf die beiden elektrischen Kontaktierungselemente übertragen, wodurch eine besonders gute elektrische Kontaktierung für den elektrischen Abgriff bzw. eine besonders gute mechanische Halterung der Leuchtenanordnung bewirkt wird. Alternativ oder zusätzlich kann das elastische Element zwischen den zwei elektrischen Kontaktierungselementen angeordnet sein. Somit kann das elastische Element mit Bezug zu den zwei elektrischen Kontaktierungselementen raumsparend angeordnet werden.

Vorzugsweise steht das wenigstens eine elektrische Kontaktierungselement in einem nicht elektrisch abgreifenden Zustand - also insbesondere, wenn die Leuchtenanordnung mit einer bzw. der länglichen Leuchte weder elektrisch noch mechanisch verbunden ist - seitlich von der Platine hervor. Dies ist insbesondere für eine vereinfachte Montage von Vorteil, da die Sichtbarkeit des elektrischen Kontaktierungselements während der Montage der Leuchtenanordnung, beispielsweise zur Verbindung mit einer Leuchtentragschiene mittels Einstecken und/oder Eindrehen, gewährleistet bleibt. Außerdem kann somit der Federweg des elastischen Elements vergrößert werden, um somit die Rückstellkraft des elastischen Elements zu erhöhen.

Das wenigstens eine elektrische Kontaktierungselement ist vorzugsweise jeweils als Steckverbinder, vorzugsweise als Kontaktierungsstift, ausgebildet. Somit können eine besonders gute elektrische Kontaktierung bzw. mechanische Kontaktierung bezweckt werden.

Die Leuchtenanordnung kann eine Lösevorrichtung zum Lösen des elektrischen Abgriffs und/oder der mechanischen Halterung der Leuchtenanordnung aufweisen. Dies ermöglicht insbesondere, dass der elektrische Abgriff bzw. die mechanische Halterung einfach, beispielsweise werkzeuglos bzw. nur händisch gelöst werden kann.

Vorzugsweise ist die Lösevorrichtung eingerichtet, das elastische Element entgegen dessen Rückstellkraft zu drücken, um somit den elektrischen Abgriff und/oder die mechanische Halterung zu lösen. Durch die Lösevorrichtung kann somit die durch das elastische Element bereitgestellte kraftschlüssige Verbindung zum elektrischen Abgriff bzw. zur mechanischen Halterung einfach aufgelöst werden, um somit anschließend beispielsweise per Hand die Leuchtenanordnung aus der Montageposition zu entfernen.

Vorzugsweise weist die Stirnseite ein optisches Element zur Auskopplung von Licht aus der Leuchtenanordnung auf. Somit kann vorteilhaft bezweckt werden, dass die schmale Dunkelstelle, welche noch durch die Stirnseite bzw. Breite der Platine vorhanden ist, durch die Lichtauskopplung des optischen Elements nach außerhalb der Leuchtenanordnung komplett verschwindet oder wenigstens reduziert ist. Auf diese Weise kann insbesondere eine durchgehende Lichtabgabe der länglichen Leuchte bzw. Lichtbandleuchte erzeugt werden, sodass die Leuchtenanordnung im Normalbetrieb der Leuchte im Wesentlichen nicht mehr auffällt.

Das optische Element kann derart ausgebildet sein, dass in das optische Element eingekoppeltes Licht aus dem optischen Element im Wesentlichen über eine (gesamte) Vorderseite der Stirnseite verteilt aus der Leuchtenanordnung ausgekoppelt wird. Unter der Vorderseite der Stirnseite wird hierbei insbesondere die zur Lichtabgabe gerichtete Seite der Stirnseite verstanden und/oder die zu der Rückseite der Stirnseite (siehe oben) abgewandte bzw. gegenüberliegende Seite der Stirnseite. Mit anderen Worten kann das optische Element bewirken, dass die Stirnseite von außerhalb der Leuchte gesehen heller erscheint, also die durch die Stirnseite bedingte Dunkelstelle reduziert ist. Beispielsweise kann das optische Element derart ausgebildet sein, dass das von dem Leuchtmittel (beispielsweise auf Dauerschaltung betrieben) und/oder von einem zum Leuchtmittel und/oder zur Leuchtenanordnung benachbarten Leuchtmittel abgestrahlte Licht das in das optische Element eingekoppelte Licht ist. Somit kann das ohnehin für eine Lichtabstrahlung bereitgestellte Licht, insbesondere das Streulicht des abgestrahlten Lichts (also Licht, das nicht für die eigentliche Lichtabgabe genutzt werden kann), gleichzeitig zur Reduzierung der durch die Stirnseite bedingten Dunkelstelle genutzt werden. Die Dunkelstelle kann auf diese Weise besonders effizient reduziert werden.

Vorzugsweise weist das optische Element ein Lichtleitelement, ein Reflektorelement und/oder ein Linsenelement auf.

Das optische Element kann eine Abdeckung der Leuchtenanordnung sein. Somit kann das optische Element gleichzeitig zum Schutz wenigstens des Leuchtmittels und/oder der Platine dienen.

Das optische Element kann aus einem transparenten Kunststoff wie beispielsweise Polycarbonat hergestellt sein.

Das Betriebsgerät ist vorzugsweise eingerichtet, nur mit einer Gleichspannung (also nicht mit einer Wechselspannung), beispielsweise bereitgestellt von einem Energiespeicher, insbesondere einer Batterie, betrieben zu werden. Somit kann das Betriebsgerät und folglich auch dessen Platine besonders kompakt ausgestaltet werden.

Vorzugsweise ist das Betriebsgerät eingerichtet, mit einer Spannung im Bereich von 20 bis 60 V, vorzugsweise im Bereich von 24 bis 48 V, betrieben zu werden.

Das Betriebsgerät kann Komponenten zum Programmieren der Leuchtenanordnung aufweisen. Diese Komponenten können insbesondere Komponenten zur drahtlosen Übertragung von Daten sein, beispielsweise eine NFC- und/oder Bluetooth-Schnittstelle. Folglich kann die Leuchtenanordnung (insbesondere dessen Lichtabgabe, Lichtfarbe etc.) beispielsweise mittels einer mobilen Kommunikationseinheit (Smartphone etc.) definiert eingestellt werden, um die Leuchtenanordnung beispielsweise an bestimmte Bedingungen flexibel anzupassen.

Vorzugsweise weist die Leuchtenanordnung ein Gehäuse auf, das wenigstens das Betriebsgerät und das Leuchtmittel aufnimmt. Durch das Gehäuse können somit insbesondere das Betriebsgerät bzw. die Platine und das Leuchtmittel in einer definierten Position zueinander gehalten werden. Ferner dient das Gehäuse zur elektrischen Isolierung und zum mechanischen Schutz der Leuchtenanordnung.

Für eine besonders kompakte Anordnung der Leuchtenanordnung in bzw. an der länglichen Leuchte kann das Gehäuse ausgebildet sein, sich senkrecht zur Längsachse der länglichen Leuchte zu erstrecken, wenn die Leuchtenanordnung in der länglichen Leuchte zur Lichtabstrahlung vorgesehen ist. Mit anderen Worten kann das Gehäuse entsprechend zu dem Betriebsgerät bzw. der Platine ausgebildet sein.

Die Platine ist senkrecht zur Erstreckungsebene der Platine gesehen vorzugsweise im Wesentlichen rechteckig ausgebildet. Dies ist insbesondere für eine besonders kompakte Bauweise der Leuchtenanordnung und eine reduzierte Dunkelstelle von Vorteil.

Die Platine kann parallel zur Erstreckungsebene der Platine gesehen dünnwandig ausgebildet sein. Das heißt, die Breite der Platine ist vorzugsweise dünnwandig bzw. dünn oder schmal ausgebildet.

Die Platine, d. h. dessen Stirnseite, weist vorzugsweise eine Breite im Bereich von 1 bis 5 cm, bevorzugt im Bereich von 2 bis 4 cm, besonders bevorzugt im Bereich von 2 bis 3 cm, auf.

Die Platine ist vorzugsweise als Montagevorrichtung zur Montage der Leuchtenanordnung ausgebildet. Somit kann die Platine die erforderliche Steifigkeit zur Montage und zum Tragen der Leuchtenanordung, beispielsweise zur Montage in eine Leuchtentragschiene, aufweisen. Folglich kann insbesondere auf ein entsprechendes Gehäuse oder sonstige versteifende Elemente verzichtet werden. Die Leuchtentragschiene stellt dann den mechanischen Schutz für die Leuchtenanordnung bereit.

In einem bevorzugten Beispiel ist die Leuchtenanordnung eine Notleuchte.

### 4. Beschreibung einer bevorzugten Ausführungsform:

Nachfolgend wird eine detaillierte Beschreibung der Figuren gegeben. In den Figuren zeigen:
- **Figur 1**: eine schematische perspektivische Ansicht einer bevorzugten Ausführungsform einer Leuchtenanordnung für eine erfindungsgemäße längliche Leuchte; und
- **Figur 2**: eine schematische perspektivische Ansicht einer bevorzugten Ausführungsform einer erfindungsgemäßen länglichen Leuchte mit der in Figur 1 dargestellten Leuchtenanordnung.

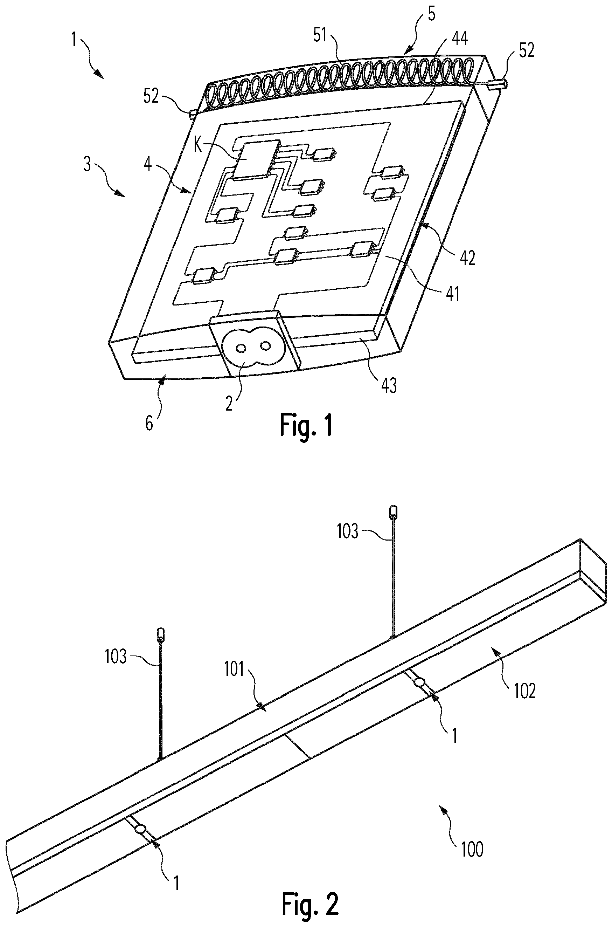

In der Figur 1 ist eine Leuchtenanordnung 1 gemäß einer bevorzugten Ausführungsform erkennbar. Die Leuchtenanordnung 1 kommt beispielsweise in einer wie in der Figur 2 beispielhaft dargestellten länglichen Leuchte 100 (beispielsweise ein Lichtband) zum Einsatz, die eine Längsachse aufweist. Länglich bedeutet dabei, dass die Leuchte 100 eine Länge aufweist, die einem Vielfachen der Breite der Leuchte 100 entspricht. Die Leuchte 100 weist vorzugsweise eine Leuchtentragschiene 101 auf, die entsprechend zu der Leuchte 100 ebenfalls länglich ausgebildet ist. Die Leuchtenschiene 101 kann eine Aufhängung 103, beispielsweise ein Seil, aufweisen, über welche die Leuchte 100 an einer Decke oder dergleichen aufgehängt werden kann. Die Leuchte 100 weist gemäß der Erfindung wenigstens ein Primärleuchtmittel zur

Abstrahlung von Licht auf, wobei dieses Licht insbesondere zur Allgemeinbeleuchtung, um beispielsweise einen Raum oder einen Gang auszuleuchten, abgestrahlt wird. Das Primärleuchtmittel kann beispielsweise in einem Lichtbalken 102 aufgenommen sein, wobei der Lichtbalken 102 wiederum von der Leuchtentragschiene 101 aufgenommen ist.

Die Leuchtenanordnung 1 ist jedoch nicht auf eine bestimmte Leuchte beschränkt. Beispielsweise kann die Leuchtenanordnung 1 auch eigenständig
als Leuchte zum Einsatz kommen (nicht gemäß der Erfindung), beispielsweise als eine Notleuchte, Sicherheitsleuchte oder allgemein als eine Leuchte, die mit einer niedrigen elektrischen Leistung betrieben wird (Signalleuchten, Notbeleuchtung etc.).

Wie die Figur 1 gut erkennen lässt, weist die Leuchtenanordnung 1 ein Leuchtmittel 2 zur Abstrahlung von Licht auf. Das Leuchtmittel 2 ist beispielsweise eine LED. Das Leuchtmittel 2 kann mehrere, beispielsweise zwei oder mehr Leuchtmittel aufweisen. Das Leuchtmittel 2 kann Teil eines Leuchtmittel-Moduls sein, wobei das Leuchtmittel-Modul neben dem Leuchtmittel 2 noch andere, insbesondere lichtbeeinflussende optische Elemente und/oder Elemente zum Betrieb des Leuchtmittels 2 aufweisen kann. Bei Anwendung der Leuchtenanordnung 1 in der Leuchte 100 kommt das Leuchtmittel 2 als Sekundärleuchtmittel zum Einsatz, um somit nicht primär als Allgemeinbeleuchtung oder dergleichen zu dienen, sondern um beispielsweise in der Funktion als Notleuchte einen Fluchtweg anzuzeigen.

Die Leuchtenanordnung 1 weist ferner ein Betriebsgerät 3 auf. Das Betriebsgerät 3 ist ein Niedervolt-Betriebsgerät, beispielsweise ausgebildet als Niederspannungs-Notlichtbetriebsgerät, und kann somit raumsparender ausgeführt werden als ein Betriebsgerät, das mit einer höheren Spannung, insbesondere mit 230 V, gespeist wird. Das heißt, da das Betriebsgerät 3 mit einer Kleinspannung gespeist bzw. betrieben wird, können gewisse Komponenten (AC/DC-Wandler, gewisse Kondensatoren, Akku etc.) entfallen. Bevorzugt ist das Betriebsgerät 3 eingerichtet, nur mit einer Gleichspannung betrieben zu werden. Diese Gleichspannung kann beispielsweise von einem entsprechenden Energiespeicher, insbesondere einer Batterie, bereitgestellt sein. Die Batterie ist vorzugsweise Teil einer sogenannten Gruppenbatterie-Anlage, die mit Niederspannung arbeitet. Eine solche Gruppenbatterie-Anlage weist zum Beispiel zwei Batterieblöcke auf, die eine Vielzahl von Leuchten mit elektrischer Energie versorgt. Das Betriebsgerät 3 ist vorzugsweise eingerichtet, (nur) mit einer Spannung im Bereich von 20 bis 60 V, vorzugsweise im Bereich von 24 bis 48 V, insbesondere mit 24 und/oder 48 V, betrieben zu werden.

Das Betriebsgerät 3 ist vorgesehen, das Leuchtmittel 2 mit einer Versorgungsspannung zu betreiben. Vorzugsweise ist das Betriebsgerät 3 zudem eingerichtet, die Lichtabgabe des Leuchtmittels 2, insbesondere die Helligkeit und/oder die Lichtfarbe des von dem Leuchtmittel 2 abgestrahlten Lichts, einzustellen. Das Betriebsgerät 3 kann Komponenten (Elektronik, Chips etc.) zum Programmieren der Leuchtenanordnung 1, insbesondere für die Lichtabgabe des Leuchtmittels 2, aufweisen. Diese Komponenten können insbesondere Komponenten zur drahtlosen Übertragung von Daten aufweisen, beispielsweise eine NFC- und/oder Bluetooth-Schnittstelle. Somit kann ein Nutzer der Leuchtenanordnung 1 beispielsweise über eine mobile Kommunikationseinheit, insbesondere über ein Smartphone und/oder eine Fernbedienung, die Leuchtenanordnung 1 entsprechend programmieren.

Das Leuchtmittel 2 und/oder das das Leuchtmittel 2 aufnehmende Leuchtmittelmodul weist vorzugsweise ein elektrisches Kontaktierungselement auf, sodass das Leuchtmittel 2 Spannung und/oder Strom von dem Betriebsgerät 3 abgreifen kann. Das Leuchtmittel 2 kann lösbar oder unlösbar mit dem Betriebsgerät 3 elektrisch und/oder mechanisch verbunden sein, beispielsweise über korrespondierende Kontaktierungselemente und/oder eine Lötverbindung.

Das Betriebsgerät 3 weist ferner eine Platine 4 auf, die zwei flächige, sich im Wesentlichen parallel zu einer Erstreckungsebene der Platine 4 erstreckende Seiten 41, 42 aufweist. Die flächigen Seiten 41, 42 sind eine Oberseite 41 und eine der Oberseite 41 gegenüberliegende Unterseite 42. In Figur 1 ist insbesondere die Oberseite 41 gut erkennbar. Die Oberseite 41 weist vorzugsweise alle oder einen Teil bzw. Großteil der Komponenten K (Elektronik, Chips etc.) des Betriebsgeräts 3 sowie die elektrischen Verbindungen, insbesondere entsprechenden Leitungen bzw. Verkabelungen, auf. Senkrecht zur Erstreckungsebene der Platine 4 gesehen, also beispielsweise senkrecht zu der Oberseite 41 bzw. in Richtung des Normalenvektors der Oberseite 41 gesehen, ist die Platine 4 vorzugsweise rechteckig ausgebildet bzw. weist eine rechteckige Form auf. Die Platine 4 kann jedoch auch andere Formen aufweisen, beispielsweise eine runde, quadratische oder sonstige mehreckige Form. Die Platine 4 ist parallel zur Erstreckungsebene bzw. Oberseite 41 der Platine 4 gesehen vorzugsweise dünnwandig ausgebildet bzw. hat eine dünne Breite (Dicke). Die Breite der Platine 4 liegt vorzugsweise im Bereich von 1 bis 5 cm, bevorzugt im Bereich von 2 bis 4 cm, besonders bevorzugt im Bereich von 2 bis 3 cm.

Die Platine 4 weist ferner eine umlaufende Stirnseite 43 auf, die die zwei flächigen Seiten 41, 42 (direkt) miteinander verbindet. Die Stirnseite 43 ist vorzugsweise senkrecht zu der Erstreckungsebene der Platine 4 bzw. senkrecht zu der Oberseite 41 und/oder Unterseite 42 vorgesehen. Die Breite der Stirnseite 43 entspricht vorzugsweise der Breite bzw. Dicke der Platine 4. Die Stirnseite 43 ist vorzugsweise länglich ausgebildet.

Erfindungsgemäß ist das Leuchtmittel 2 auf Seiten der Stirnseite 43 der Platine 4 angeordnet, wobei in dem in der Figur 1 gezeigten bevorzugten Ausführung der Leuchtenanordnung 1 das Leuchtmittel 2 bevorzugt auf der Stirnseite 43 (direkt) angeordnet ist. Die Stirnseite 43 weist vorzugsweise eine Vorderseite auf, die auf Seiten der Lichtabgabe der Leuchtenanordnung 1 vorgesehen, wobei das Leuchtmittel 2 auf Seiten der Vorderseite oder auf dieser angeordnet ist. Demnach weist die umlaufende Stirnseite 43 vorzugsweise auch eine Rückseite 44 auf, die der Vorderseite der Stirnseite 43 abgewandt ist bzw. gegenüberliegt. Dadurch, dass das Leuchtmittel 2 nunmehr auf der verhältnismäßig schmalen Stirnseite 43 vorgesehen ist, ist die Dunkelstelle bzw. Schattenfuge der Leuchtenanordnung 1 nur noch durch die Breite und Höhe der Stirnseite 43 bzw. Platine 4 definiert. Somit ist die Dunkelstelle erheblich reduziert, und die Leuchtenanordnung 1 ist hinsichtlich ihrer Breite bzw. Dicke ebenfalls erheblich reduziert. Die Leuchtenanordnung 1 kann somit bezüglich der Leuchte 100 derart angeordnet werden, dass die Erstreckungsebene der Platine 4 im Wesentlichen senkrecht zur Längsachse der Leuchte 100 ist. Die Leuchtenanordnung 1 nimmt somit bei Anwendung in der Leuchte 100 wesentlich weniger Platz in Richtung der Längsachse der Leuchte 100 in Anspruch, sodass die durch die Leuchtenanordnung 1 gebildete Dunkelstelle bzw. Schattenfuge, beispielsweise zwischen zwei Lichtbalken 102, verkleinert ist und somit fast nicht mehr auffällt. Zudem kann somit die Leuchte 100 kürzer ausgeführt werden.

Das Leuchtmittel 2 kann an der Stirnseite 43 mit einem Befestigungsmittel befestigt sein. Das Befestigungsmittel kann ein kraft-, form-, und/oder formschlüssiges Befestigungsmittel sein. Beispielsweise ist das Leuchtmittel 2 mittels einander korrespondierender Befestigungsmittel, insbesondere mittels einer Rast- oder Schnappverbindung, an der Stirnseite 43 befestigt. Geeignete stoffschlüssige Befestigungsmittel sind beispielsweise eine Klebe- und/oder Lötverbindung.

Durch die erfindungsgemäße Anordnung des Leuchtmittels 2 auf Seiten der Stirnseite 43 ist die Dunkelstelle wegen der verhältnismäßig schmalen Stirnseite 43 somit kaum mehr von außerhalb der Leuchtenanordnung 1, allenfalls als Schattenfuge, erkennbar. Um die (nur) durch die Stirnseite 43 bzw. dessen Vorderseite bedingte Dunkelstelle der Leuchtenanordnung 1 noch weiter zu reduzieren, kann vorteilhaft vorgesehen sein, dass die Stirnseite 43 ein nicht näher dargestelltes optisches Element zur Auskopplung von Licht aus der Leuchtenanordnung 1 aufweist. Das optische Element ist dabei vorzugsweise derart ausgebildet und auf der Stirnseite 43 vorgesehen, dass in das optische Element eingekoppeltes Licht aus dem optischen Element im Wesentlichen über die gesamte Vorderseite der Stirnseite 43 oder über die gesamte Stirnseite 43 verteilt aus der Leuchtenanordnung 1 zur Vorderseite der Leuchtenanordnung 1 ausgekoppelt wird. Somit kann beispielsweise das bzw. ein Teil von dem Leuchtmittel 2 und/oder von einem zum Leuchtmittel 2 und/oder zu Leuchtenanordnung 1 benachbarten Leuchtmittel abgestrahlte Licht (insbesondere Streulicht), beispielsweise das von dem Primärleuchtmittel bzw. dem Lichtbalken 102 abgestrahlte Licht, als das in das optische Element eingekoppelte Licht dienen. Somit kann die von der Stirnseite 43 bedingte Dunkelstelle bei Blick von außerhalb der Leuchtenanordnung 1 bzw. Leuchte 100, also zum Beispiel bei Blick von dem durch die Leuchtenanordnung 1 bzw. Leuchte 100 ausgeleuchteten Raum, komplett verschwinden, d. h. hell erscheinen. Folglich wird das Erscheinungsbild der Leuchtenanordnung 1 und, bei Anwendung in der Leuchte 100, das Erscheinungsbild der Leuchte 100 noch weiter verbessert.

Das vorgenannte optische Element kann ein Lichtleitelement, ein Reflektorelement und/oder ein Linsenelement sein. Das optische Element kann auch andere Lichtoptiken und/oder illuminierende und/oder illuminierte Bauteile aufweisen. Das optische Element erstreckt sich vorzugsweise über die komplette Vorderseite der Stirnseite 43, also über deren komplette Breite und/oder Höhe, oder über die komplette Stirnseite 43. Vorzugsweise ist das optische Element gleichzeitig eine Abdeckung der Leuchtenanordnung 1, die vorzugsweise wenigstens das Leuchtmittel 2 und/oder das Betriebsgerät 3 schützend abdeckt. Die Abdeckung kann zudem ein Piktogramm oder dergleichen aufweisen, welches von dem Leuchtmittel durchleuchtet wird, um beispielsweise auf einen Fluchtweg hinzuweisen. Das optische Element ist vorzugsweise aus einem transparenten Kunststoff wie beispielsweise Polycarbonat hergestellt. Auch andere transparente Materialien können zur Herstellung des optischen Elements zum Einsatz kommen.

Wie in Figur 1 gut erkennbar, weist die Leuchtenanordnung 1 bzw. die Platine 4 vorzugsweise eine in der Erstreckungsebene der Platine 4 angeordnete elektrische Kontaktierungsanordnung 5 auf, über welche der elektrische Abgriff für die Leuchtenanordnung 1, also insbesondere für das Leuchtmittel 2 und das Betriebsgerät 3, erfolgt. Bei Anwendung der Leuchtenanordnung 1 in der Leuchte 100 ist die elektrische Kontaktierungsanordnung 5 also vorzugsweise ausgebildet, mit der Leuchtentragschiene 100 elektrisch verbunden zu werden (beispielsweise über korrespondierende elektrische Kontaktierungsbereiche der Leuchtentragschiene 101), um somit von der Leuchtentragschiene 101 die elektrische Energie (Strom und/oder Spannung) für den elektrischen Abgriff abzugreifen. Alternativ oder zusätzlich ist die elektrische Kontaktierungsanordnung 5 ausgebildet, die Leuchtenanordnung 1 mechanisch zu halten bzw. zu befestigen, beispielsweise an der Leuchte 100, insbesondere an deren Leuchtentragschiene 101. Hierfür kann die Leuchtentragschiene 101 einen entsprechenden korrespondierenden Bereich, beispielsweise der zuvor genannte korrespondierende Bereich zum elektrischen Abgriff, aufweisen, in den die elektrische Kontaktierungsanordnung 5 eingreift, um die Leuchte 1 zu halten bzw. zu befestigen. Dieser Bereich kann beispielsweise ein Bereich der Leuchtentragschiene 101 sein, der dediziert für die Leuchtenanordnung 1, also beispielsweise für eine Sekundärbeleuchtung wie eine Notbeleuchtung, vorgesehen ist.

Zur besonders kompakten Anordnung der elektrischen Kontaktierungsanordnung 5 ist diese vorzugsweise Seiten der Stirnseite 43 bzw. auf dieser vorgesehen. In dem in Figur 1 gezeigten Ausführungsbeispiel der Leuchtenanordnung 1 ist die elektrische Kontaktierungsanordnung 5 bevorzugt auf einer dem Leuchtmittel 2 und/oder der Vorderseite der Stirnseite 43 abgewandten Seite der Stirnseite 43, also beispielsweise auf der Rückseite 44 der Stirnseite 43, angeordnet. Durch die Anordnung der elektrischen Kontaktierungsanordnung 5 auf der Rückseite 44 der Stirnseite 43 wird vorteilhaft bezweckt, dass die Leuchtenanordnung 1 besonders einfach elektrisch und/oder mechanisch verbunden werden kann, beispielsweise an der Leuchte 100.

Die Erfindung ist jedoch nicht darauf beschränkt, dass die elektrische Kontaktierungsanordnung 5 auf der Rückseite 44 angeordnet ist. Beispielsweise ist es auch denkbar, dass die elektrische Kontaktierungsanordnung 5 alternativ oder zusätzlich auf einer oder beider der Seitenflächen der Platine 4 angeordnet ist, die die Vorderseite der Stirnseite 43 mit der Rückseite 44 der Stirnseite 43 verbinden.

Vorzugsweise weist die elektrische Kontaktierungsanordnung 5 ein elastisches Element 51 auf, welches in dem Ausführungsbeispiel gemäß Figur 1 bevorzugt als eine Feder, insbesondere als eine Spiral- und/oder Schraubenfeder, ausgebildet ist. Das elastisch Element 51 ist vorzugsweise in einem vorzugsweise aus Kunststoff hergestellten Gehäuse aufgenommen, beispielsweise in dem weiter unten beschriebene Gehäuse. Das elastische Element 51 ist dabei so angeordnet, dass eine Rückstellkraft bzw. Federkraft des elastischen Elements 51 den elektrischen Abgriff und/oder die mechanische Halterung der Leuchtenanordnung 1 unterstützt. Das heißt, die Rückstellkraft des elastischen Elements 51 drückt entsprechende Bereiche der elektrischen Kontaktierungsanordnung 5 in zu diesen Bereichen korrespondierend ausgestaltete Bereiche, um somit eine Kraft an der jeweiligen Kontaktierungsstelle zu bewirken, die den elektrischen Abgriff und/oder die mechanische Halterung der Leuchtenanordnung 1 unterstützt bzw. festigt. Kommt die Leuchtenanordnung 1 also beispielsweise in der Leuchte 100 zum Einsatz, so bewirkt das elastische Element 51, dass die elektrische Kontaktierungsanordnung 5 und somit die Leuchtenanordnung 1 in sicheren Kontakt mit der Leuchtentragschiene 101 zum elektrischen Abgriff und/oder zur mechanischen Halterung der Leuchtenanordnung 1 ist.

Wie die Figur 1 gut erkennen lässt, weist die elektrische Kontaktierungsanordnung 5 vorzugsweise wenigstens ein elektrisches Kontaktierungselement 52 auf. Das elektrische Kontaktierungselement 52 ist vorzugsweise ausgestaltet, über eine elektrische Kontaktierung den elektrischen Abgriff bereitzustellen und/oder die Leuchtenanordnung 1 mechanisch zu halten. Das heißt, das elektrische Kontaktierungselement 52 ist vorzugsweise ausgestaltet, in einen zu dem elektrischen Kontaktierungselement 52 korrespondierend ausgestalteten Bereich einzugreifen, um somit die elektrische Kontaktierung und/oder die mechanische Halterung der Leuchtenanordnung 1 zu bewirken. Beispielsweise weist die Leuchtentragschiene 101 einen solchen Bereich auf, beispielsweise ausgestaltet als eine Aussparung und/oder eine elektrische Kontaktierungstelle, die bevorzugt in der Aussparung vorgesehen ist. In den Bereich kann dann das elektrische Kontaktierungselement 52 eingreifen, um den elektrischen Abgriff und/oder die mechanische Halterung der Leuchtenanordnung 1 zu bewirken. Somit kann mit Blick auf Figur 2 die Leuchtenanordnung 1 mit der Leuchte 100 elektrisch und/oder mechanisch verbunden werden, indem die Leuchtenanordnung 1 in einer Richtung senkrecht zur Längsachse der Leuchte 100, also in Figur 2 in einer Richtung von unten nach oben, mit der Leuchte 100 elektrisch und/oder mechanisch verbunden wird.

Mit Bezug zu dem elastischen Element 51 ist das elektrische Kontaktierungselement 52 vorzugsweise so angeordnet, dass durch die Rückstellkraft des elastischen Elements 51 das elektrische Kontaktierungselement 52 in eine Stellung zur elektrischen Kontaktierung für den elektrischen Abgriff und/oder in eine Stellung zur mechanischen Halterung der Leuchtenanordnung 1 gedrückt wird, also beispielsweise in den zuvor beschriebenen zu dem elektrische Kontaktierungselement 52 korrespondierend ausgestalteten Bereich. Somit kann gewährleistet werden, dass das elektrische Kontaktierungselement 52 für den elektrischen Abgriff und/oder für die mechanische Halterung der Leuchtenanordnung 1 stets in Eingriff ist und/oder etwaige vorhandene Toleranzen der Leuchtentragschiene 101 ausgleicht.

Bevorzugt steht das elektrische Kontaktierungselement 52 in einem nicht elektrisch abgreifenden Zustand, also beispielsweise wenn die Leuchtenanordnung 1 noch nicht mit der Leuchte 1 elektrisch und/oder mechanisch verbunden ist, seitlich von der Platine 4 hervor. Dementsprechend wird beim Verbinden der Leuchtenanordnung 1 mit der Leuchte 100 das elektrische Kontaktierungselement 52 zunächst gegen die Feder gedrückt, welche sich folglich komprimiert und somit die Rückstellkraft auf das elektrische Kontaktierungselement 52 ausübt. Sobald die Leuchtenanordnung 1 in der bestimmungsgemäßen Montageposition ist, drückt die Rückstellkraft des elastischen Elements 51 das elektrische Kontaktierungselement 52 von sich weg, sodass das elektrische Kontaktierungselement 52 schließlich in Eingriff mit dem korrespondierend zu dem elektrischen Kontaktierungselement 52 ausgeschalteten Bereich, beispielsweise ausgebildet in der Leuchtentragschiene 101, kommt. Die Leuchtenanordnung 1 ist somit elektrisch kontaktiert und/oder mechanisch sicher gehalten.

Alternativ oder zusätzlich kann jedoch auch vorgesehen sein, dass die Leuchtenanordnung 1, statt (nur) von unten, seitlich in die Leuchtentragschiene 101, also in einer Richtung parallel zur Längsachse der Leuchte 100, eingebracht wird. Beispielsweise kann das elektrische Kontaktierungselement 52 zunächst in einer Richtung seitlich von der Leuchte 100, also in einer Richtung parallel zur Längsachse der Leuchte 100, in die Leuchte 100 bzw. Leuchtentragschiene 101 eingebracht werden, um den elektrischen Abgriff und/oder die mechanische Halterung zu bewirken. Anschließend wird dann die Stirnseite 43 der Leuchtenanordnung 1 in die Leuchte 100 bzw. Tragschiene 101 hineingedreht, beispielsweise um eine durch die von dem elektrischen Kontaktierungselement 52 bereitgestellte Drehachse, bis die Leuchtenanordnung 1 einen Anschlag erreicht, beispielsweise ein Anschlag zu einem benachbarten Leuchtbalken 102.

Die elektrische Kontaktierungsanordnung 5 weist vorzugsweise wenigstens zwei elektrische Kontaktierungselemente 52 auf, welche bevorzugt identisch zueinander ausgestaltet sind. Das bezüglich des elektrische Kontaktierungselement 52 Gesagte gilt also für das weitere elektrischen Kontaktierungselements 52 analog. Die zwei elektrischen Kontaktierungselemente 52 sind vorzugsweise sich gegenüberliegend angeordnet. Vorzugsweise ist das elastische Element 51 derart angeordnet, dass die Rückstellkraft des elastischen Elements 51 die zwei elektrischen Kontaktierungselemente 52 voneinander weg und in eine Stellung zur elektrischen Kontaktierung für den elektrischen Abgriff und/oder in eine Stellung zur mechanischen Halterung gedrückt werden. Vorzugsweise ist das elastische Element 51 zwischen den beiden elektrischen Kontaktierungselementen 52 angeordnet. Beispielsweise weist das elektrische Kontaktierungselement 51 freie Enden auf, auf welchen jeweils eines der zwei elektrischen Kontaktierungselemente 52 vorgesehen sind.

Das wenigstens eine elektrische Kontaktierungselement 52 ist jeweils vorzugsweise als Steckverbinder, besonders bevorzugt als Kontaktierungsstift, ausgebildet.

Die Leuchtenanordnung 1 kann ferner eine nicht näher dargestellte Lösevorrichtung zum Lösen des elektrischen Abgriffs und/oder der mechanischen Halterung der Leuchtenanordnung 1 aufweisen. Die Lösevorrichtung ist vorzugsweise eingerichtet, das elastische Element 51 entgegen dessen Rückstellkraft zu drücken, um somit den elektrischen Abgriff und/oder die mechanische Halterung zu lösen. Die Lösevorrichtung kann beispielsweise ein Betätigungselement aufweisen, über welches die Lösevorrichtung zum Lösen des elektrischen Abgriffs und/oder der mechanischen Halterung der Leuchtenanordnung 1 betätigt werden kann. Das Betätigungselement kann auf der Stirnseite 43 angeordnet sein, um somit eine gute Zugänglichkeit der Lösevorrichtung, beispielsweise von unterhalb Leuchte 100, zu gewährleisten. Mittels der Lösevorrichtung kann somit die Leuchtenanordnung 1 insbesondere einfach, insbesondere werkzeuglos aus der Leuchte 100 entnommen werden.

Alternativ oder zusätzlich kann auch vorgesehen sein, dass das jeweils zu der Leuchtenanordnung 1 benachbarte Leuchtelement wie beispielsweise der Leuchtbalken 102 zunächst von der Leuchte 100 entfernt wird und anschließend das elastische Element 51, beispielsweise händisch oder mit einem Werkzeug, betätigt wird, um die Leuchtenanordnung 1 zu entriegeln und somit aus der Leuchtentragschiene 101 zu entnehmen, beispielsweise mittels Drehung.

Wie die Figur 1 gut erkennen lässt, weist die Leuchtenanordnung 1 vorzugsweise ein Gehäuse 6 auf, das wenigstens das Betriebsgerät 3 bzw. die Platine 4 und das Leuchtmittel 2, vorzugsweise auch die elektrische Kontaktierungsanordnung 5 und/oder das optische Element, aufnimmt. Vorzugsweise nimmt das Gehäuse 6 die elektrische Kontaktierungsanordnung 5 derart auf, dass das elektrische Kontaktierungselement 52 seitlich von dem Gehäuse hervorsteht. Das Gehäuse 6 bewirkt insbesondere, dass die von dem Gehäuse 6 aufgenommenen Teile der Leuchtenanordnung 1, also insbesondere das Leuchtmittel 2, die Platine 4, die elektrische Kontaktierungsanordnung 5 und/oder das optische Element, in definierten Positionen zueinander aufgenommen sind und/oder elektrisch isoliert sind und/oder vor Umwelteinflüssen geschützt sind. Das Leuchtmittel 2, vorzugsweise samt optischem Element, ist vorzugsweise in einem vorderen Teil des Gehäuses 6 angeordnet, wobei die elektrische Kontaktierungsanordnung 5 vorzugsweise in einem hinteren Teil des Gehäuses 6 angeordnet ist. Das Betriebsgerät 3 samt Platine 4 ist vorzugsweise zwischen Leuchtmittel 2 und elektrischer Kontaktierungsanordnung 5 angeordnet. Ist die Leuchtenanordnung 1 samt Gehäuse 6 in bzw. an der länglichen Leuchte 100 zur Lichtabstrahlung vorgesehen, so ist das Gehäuse 6 vorzugsweise derart ausgebildet, dass dieses sich senkrecht zur Längsachse der länglichen Leuchte 100 erstreckt. Das Gehäuse 6 weist also vorzugsweise eine Form auf, die der Form der Platine 4 entspricht, beispielsweise eine kastenförmige und/oder quaderförmige Form.

Zur einfachen Montage der Leuchtenanordnung 1 kann, alternativ oder zusätzlich zu dem wie zuvor beschriebenen Gehäuse 6, die Platine 4 als Montagevorrichtung ausgebildet sein. Die Platine 4 kann also beispielsweise eine entsprechende Steifigkeit aufweisen, welche es ermöglicht, dass die Leuchtenanordnung 1 ohne Gehäuse 6 oder sonstige tragende oder versteifende Elemente mit einer Leuchte wie beispielsweise der Leuchte 100 bzw. dessen Tragschiene 101 elektrisch und/oder mechanisch verbunden werden kann.

Die vorliegende Erfindung ist jedoch nicht auf das vorhergehende bevorzugte Ausführungsbeispiel beschränkt, solange sie vom Gegenstand der folgenden Ansprüche umfasst ist.

## Patentansprüche

1. Längliche Leuchte (100) mit einer Längsachse, aufweisend ein Primärleuchtmittel zur Abstrahlung von Licht und eine Leuchtenanordnung (1), wobei die Leuchtenanordnung (1) aufweist:
ein Leuchtmittel (2) zur Abstrahlung von Licht, und
ein Niedervolt-Betriebsgerät (3) zur Versorgung des Leuchtmittels (2) mit einer Versorgungsspannung, wobei das Betriebsgerät (3) eine Platine (4) aufweist, wobei die Platine (4) zwei flächige, sich im Wesentlichen parallel zu einer Erstreckungsebene der Platine (4) erstreckende Seiten (41, 42) und eine die zwei flächigen Seiten (41, 42) verbindende umlaufende Stirnseite (43) aufweist, und wobei die Erstreckungsebene der Platine (4) im Wesentlichen senkrecht zur Längsachse der Leuchte (100) ist,
wobei das Leuchtmittel (2) auf Seiten der Stirnseite (43) der Platine (4) angeordnet ist, und wobei das Leuchtmittel (2) der Leuchtenanordnung (1) ein Sekundärleuchtmittel der länglichen Leuchte (100) ist.

2. Längliche Leuchte (100) nach Anspruch 1, wobei die Platine (4) eine in der Erstreckungsebene angeordnete elektrische Kontaktierungsanordnung (5) zum elektrischen Abgriff für die Leuchtenanordnung (1) und/oder zur mechanischen Halterung der Leuchtenanordnung (1) aufweist.

3. Längliche Leuchte (100) nach Anspruch 2, wobei die elektrische Kontaktierungsanordnung (5) mit einer Leuchtentragschiene (101) der länglichen Leuchte (100) verbindbar ist, um von der Leuchtentragschiene (101) für den elektrischen Abgriff elektrische Energie abzugreifen und/oder um die Leuchtentanordnung (1) an der Leuchtentragschiene (101) mechanisch zu halten.

4. Längliche Leuchte (100) nach Anspruch 2 oder 3, wobei die Stirnseite (43) die elektrische Kontaktierungsanordnung (5) aufweist, wobei vorzugsweise eine dem Leuchtmittel (2) abgewandte Seite der Stirnseite (43), beispielsweise eine Rückseite (44) der Platine (4), die elektrische Kontaktierungsanordnung (5) aufweist.

5. Längliche Leuchte (100) nach einem der Ansprüche 2 bis 4, wobei die elektrische Kontaktierungsanordnung (5) ein elastisches Element (51), vorzugsweise eine Feder, besonders bevorzugt eine Spiral- und/oder Schraubenfeder, aufweist, welches derart angeordnet ist, dass eine Rückstellkraft des elastischen Elements (51) den elektrischen Abgriff und/oder die mechanische Halterung der Leuchtenanordnung (1) unterstützt.

6. Längliche Leuchte (100) nach einem der Ansprüche 2 bis 5, wobei die elektrische Kontaktierungsanordnung (5) wenigstens ein elektrisches Kontaktierungselement (52) zur elektrischen Kontaktierung für den elektrischen Abgriff und/oder zur mechanischen Halterung der Leuchtenanordnung (1) aufweist, und wobei vorzugsweise das elastische Element (51) derart angeordnet ist, dass durch die Rückstellkraft des elastischen Elements (51) das wenigstens eine elektrische Kontaktierungselement (52) in eine Stellung zur elektrischen Kontaktierung für den elektrischen Abgriff und/oder in eine Stellung zur mechanischen Halterung der Leuchtenanordnung (1) gedrückt wird,
wobei vorzugsweise die elektrische Kontaktierungsanordnung (5) wenigstens zwei elektrische Kontaktierungselemente (52) aufweist, und wobei das elastische Element (51) bevorzugt derart angeordnet ist, dass durch die Rückstellkraft des elastischen Elements (51) die wenigstens zwei elektrischen Kontaktierungselemente (52) voneinander weg und in eine Stellung zur elektrischen Kontaktierung für den elektrischen Abgriff und/oder in eine Stellung zur mechanischen Halterung gedrückt werden, und/oder wobei das elastische Element (51) bevorzugt zwischen den zwei elektrischen Kontaktierungselementen (52) angeordnet ist, und/oder
wobei vorzugsweise das wenigstens eine elektrische Kontaktierungselement (51) in einem nicht elektrisch abgreifenden Zustand seitlich von der Platine (4) hervorsteht, und/oder
wobei vorzugsweise das wenigstens eine elektrische Kontaktierungselement (52) jeweils als Steckverbinder, vorzugsweise als Kontaktierungsstift, ausgebildet ist.

7. Längliche Leuchte (100) nach einem der Ansprüche 2 bis 6, wobei die Leuchtenanordnung (1) ferner eine Lösevorrichtung zum Lösen des elektrischen Abgriffs und/oder der mechanischen Halterung der Leuchtenanordnung (1) aufweist,
wobei die Lösevorrichtung vorzugsweise eingerichtet ist, das elastische Element (51) entgegen dessen Rückstellkraft zu drücken, um somit den elektrischen Abgriff und/oder die mechanische Halterung zu lösen.

8. Längliche Leuchte (100) nach einem der vorhergehenden Ansprüche, wobei die Stirnseite (43) ein optisches Element zur Auskopplung von Licht aus der Leuchtenanordnung (1) aufweist,
wobei vorzugsweise das optische Element derart ausgebildet ist, dass in das optische Element eingekoppeltes Licht, beispielsweise von dem Leuchtmittel (2) und/oder von einem zum Leuchtmittel (2) und/oder zur Leuchtenanordnung (1) benachbarten Leuchtmittel abgestrahltes Licht, aus dem optischen Element im Wesentlichen über eine Vorderseite der Stirnseite (43) verteilt aus der Leuchtenanordnung (1) ausgekoppelt wird, und/oder
wobei vorzugsweise das optische Element ein Lichtleitelement, ein Reflektorelement und/oder ein Linsenelement aufweist, und/oder
wobei vorzugsweise das optische Element eine Abdeckung der Leuchtenanordnung (1) ist, und/oder
wobei vorzugsweise das optische Element aus einem transparenten Kunststoff wie beispielsweise Polycarbonat hergestellt ist.

9. Längliche Leuchte (100) nach einem der vorhergehenden Ansprüche,
wobei das Betriebsgerät (4) eingerichtet ist, nur mit einer Gleichspannung, beispielsweise bereitgestellt von einem Energiespeicher, insbesondere einer Batterie, betrieben zu werden, und/oder
wobei das Betriebsgerät (4) eingerichtet ist, mit einer Spannung im Bereich von 20 bis 60 V, vorzugsweise im Bereich von 24 bis 48 V, betrieben zu werden.

10. Längliche Leuchte (100) nach einem der vorhergehenden Ansprüche, wobei das Betriebsgerät (4) Komponenten zum Programmieren der Leuchtenanordnung aufweist, insbesondere Komponenten zur drahtlosen Übertragung von Daten, beispielsweise eine NFC- und/oder Bluetooth-Schnittstelle.

11. Längliche Leuchte (100) nach einem der vorhergehenden Ansprüche, wobei die Leuchtenanordnung (100) ein Gehäuse (6) aufweist, das wenigstens das Betriebsgerät (4) und das Leuchtmittel (2) aufnimmt,
wobei das Gehäuse (6) vorzugsweise ausgebildet ist, sich senkrecht zur Längsachse der länglichen Leuchte (100) zu erstrecken, wenn die Leuchtenanordnung (1) in der länglichen Leuchte (100) zur Lichtabstrahlung vorgesehen ist.

12. Längliche Leuchte (100) nach einem der vorhergehenden Ansprüche,
wobei die Platine (4) senkrecht zur Erstreckungsebene der Platine (4) gesehen im Wesentlichen rechteckig ausgebildet ist, und/oder
wobei die Platine (4) parallel zur Erstreckungsebene der Platine (4) gesehen dünnwandig ausgebildet ist, und/oder
wobei die Platine (4) eine Breite im Bereich von 1 bis 5 cm, bevorzugt im Bereich von 2 bis 4 cm, besonders bevorzugt im Bereich von 2 bis 3 cm, aufweist, und/oder
wobei die Platine (4) als Montagevorrichtung zur Montage der Leuchtenanordung (1) ausgebildet ist.

13. Längliche Leuchte (100) nach einem der vorhergehenden Ansprüche, wobei die Leuchtenanordnung (1) eine Notleuchte ist.

## Claims

1. Elongated luminaire (100) having a longitudinal axis, comprising a primary illuminant for emitting light and a luminaire arrangement (1), wherein the luminaire arrangement (1) comprises:
an illuminant (2) for emitting light, and
a low-voltage operating device (3) for supplying the illuminant (2) with a supply voltage, wherein the operating device (3) comprises a circuit board (4), wherein the circuit board (4) comprises two flat sides (41, 42) extending substantially parallel to an extension plane of the circuit board (4) and a circumferential end face (43) connecting the two flat sides (41, 42), and wherein the extension plane of the circuit board (4) is substantially perpendicular to the longitudinal axis of the luminaire (100),
wherein the illuminant (2) is arranged on sides of the end face (43) of the circuit board (4), and wherein the illuminant (2) of the luminaire arrangement (1) is a secondary illuminant of the elongated luminaire (100).

2. Elongated luminaire (100) according to Claim 1, wherein the circuit board (4) has an electrical contacting arrangement (5) arranged in the extension plane for electrical tapping for the luminaire arrangement (1) and/or for the mechanical mounting of the luminaire arrangement (1).

3. Elongated luminaire (100) according to Claim 2, wherein the electrical contacting arrangement (5) can be connected to a luminaire support rail (101) of the elongated luminaire (100) in order that electrical power is tapped from the luminaire support rail (101) for electrical tap and/or in order to mechanically hold the luminaire arrangement (1) on the luminaire support rail (101).

4. Elongated luminaire (100) according to Claims 2 or 3, wherein the end face (43) has the electrical contacting arrangement (5), wherein preferably a side of the end face (43) facing away from the illuminant (2), for example a rear side (44) of the circuit board (4), has the electrical contacting arrangement (5).

5. Elongated luminaire (100) according to either of Claims 2 to 4, wherein the electrical contacting arrangement (5) has an elastic element (51), preferably a spring, particularly preferably a spiral and/or coil spring, which is arranged such that a restoring force of the elastic element (51) supports the electrical tap and/or the mechanical mounting of the luminaire arrangement (1).

6. Elongated luminaire (100) according to any one of Claims 2 to 5, wherein the electrical contacting arrangement (5) has at least one electrical contacting element (52) for electrical contacting for the electrical tap and/or for the mechanical mounting of the luminaire arrangement (1), and wherein the elastic member (51) preferably is arranged such that the at least one electrical contacting element (52) is pressed by the restoring force of the elastic element (51) into a position for electrical contacting for the electrical tap and/or into a position for the mechanical mounting of the luminaire arrangement (1),
wherein preferably the electrical contacting arrangement (5) has at least two electrical contacting elements (52) and wherein the elastic element (51) is preferably arranged such that the at least two electrical contacting elements (52) are pressed by the restoring force of the elastic element (51) away from each other and into a position for electrical contacting for the electrical tap and/or into a position for the mechanical mounting, and/or wherein the elastic element (51) is preferably arranged between the two electrical contacting elements (52), and/or
wherein the at least one electrical contacting element (51) in a non-electrically tapping state preferably projects laterally from the circuit board (4), and/or
wherein the at least one electrical contacting element (52) is preferably designed in each case as a plug connector, preferably as a contact pin.

7. Elongated luminaire (100) according to any one of Claims 2 to 6, wherein the luminaire arrangement (1) further has a release device for releasing the electrical tap and/or the mechanical mounting of the luminaire arrangement (1),
wherein the release device is preferably configured to press the elastic element (51) against its restoring force, in order thus to release the electrical tap and/or the mechanical mounting.

8. Elongated luminaire (100) according to any one of the preceding claims, wherein the end face (43) has an optical element for coupling out light from the luminaire arrangement (1),
wherein the optical element is preferably designed such that light coupled into the optical element, for example from the illuminant (2), and/or light radiated from a illuminant adjacent to the illuminant (2) and/or to the luminaire arrangement (1) is coupled out of the luminaire arrangement (1) from the optical element in a manner substantially distributed over a front side of the end face (43), and/or
wherein the optical element preferably has a light guide element, a reflector element and/or a lens element, and/or
wherein the optical element is preferably a cover of the luminaire arrangement (1), and/or
wherein the optical element is preferably produced from a transparent plastic such as, for example, polycarbonate.

9. Elongated luminaire (100) according to any one of the preceding claims,
wherein the operating device (4) is configured to be operated only with a DC voltage, for example provided by an energy store, in particular a battery, and/or
wherein the operating device (4) is configured to be operated with a voltage in the range from 20 to 60 V, preferably in the range from 24 to 48 V.

10. Elongated luminaire (100) according to any one of the preceding claims, wherein the operating device (4) has components for programming the luminaire arrangement, in particular components for the wireless transmission of data, for example an NFC and/or Bluetooth interface.

11. Elongated luminaire (100) according to any one of the preceding claims, wherein the luminaire arrangement (100) has a housing (6) which accommodates at least the operating device (4) and the illuminant (2),
wherein the housing (6) is preferably designed to extend perpendicular to the longitudinal axis of the elongated luminaire (100) if the luminaire arrangement (1) is provided in the elongated luminaire (100) for light emission.

12. Elongated luminaire (100) according to any one of the preceding claims,
wherein the circuit board (4) is substantially rectangular when viewed perpendicular to the extension plane of the circuit board (4), and/or
wherein the circuit board (4) has a thin-walled design when viewed parallel to the extension plane of the circuit board (4), and/or
wherein the circuit board (4) has a width in the range from 1 to 5 cm, preferably in the range from 2 to 4 cm, particularly preferably in the range from 2 to 3 cm, and/or
wherein the circuit board (4) is designed as a mounting device for mounting the luminaire arrangement (1).

13. Elongated luminaire (100) according to any one of the preceding claims, wherein the luminaire arrangement (1) is an emergency light.

## Revendications

1. Luminaire long (100) comprenant un axe longitudinal, présentant un moyen d'éclairage primaire pour l'émission de lumière et un agencement d'éclairage (1), l'agencement d'éclairage (1) présentant :
un moyen d'éclairage (2) pour l'émission de lumière et
un appareil d'alimentation basse tension (3) pour l'alimentation du moyen d'éclairage (2) avec une tension d'alimentation, l'appareil d'alimentation (3) présentant une carte de circuit imprimé (4), la carte de circuit imprimé (4) présentant deux faces planes (41, 42) s'étendant essentiellement parallèles à un plan d'extension de la carte de circuit imprimé (4) et une face frontale périphérique (43) reliant les deux faces planes (41, 42) et le plan d'extension de la carte de circuit imprimé (4) étant essentiellement perpendiculaire à l'axe longitudinal du luminaire (100),
le moyen d'éclairage (2) étant disposé sur les côtés de la face frontale (43) de la carte de circuit imprimé (4) et le moyen d'éclairage (2) de l'agencement d'éclairage (1) étant un moyen d'éclairage secondaire du luminaire long (100).

2. Luminaire long (100) selon la revendication 1, dans lequel la carte de circuit imprimé (4) présente un dispositif de contact (5) électrique disposé dans le plan d'extension, pour le prélèvement électrique pour l'agencement d'éclairage (1) et/ou pour le support mécanique de l'agencement d'éclairage (1).

3. Luminaire long (100) selon la revendication 2, dans lequel le dispositif de contact (5) électrique peut être relié à un rail porteur de luminaire (101) du luminaire long (100), pour prélever de l'énergie électrique du rail porteur de luminaire (101) pour le prélèvement électrique et/ou pour maintenir l'agencement d'éclairage (1) mécaniquement sur le rail porteur de luminaire (101).

4. Luminaire long (100) selon la revendication 2 ou 3, dans lequel la face frontale (43) présente le dispositif de contact (5) électrique, dans lequel de préférence un côté de la face frontale (43) opposé au moyen d'éclairage (2), par exemple une face arrière (44) de la carte de circuit imprimé (4), présente le dispositif de contact (5) électrique.

5. Luminaire long (100) selon l'une quelconque des revendications 2 à 4, dans lequel le dispositif de contact (5) électrique présente un élément élastique (51), de préférence un ressort, de manière particulièrement préférée un ressort hélicoïdal et/ou en spirale, lequel est disposé de telle façon qu'une force de rappel de l'élément élastique (51) soutienne le prélèvement électrique et/ou le support mécanique de l'agencement d'éclairage (1).

6. Luminaire long (100) selon l'une quelconque des revendications 2 à 5, dans lequel le dispositif de contact (5) électrique présente au moins un élément de contact (52) électrique pour le contact électrique pour le prélèvement électrique et/ou le support mécanique de l'agencement d'éclairage (1) et dans lequel de préférence l'élément élastique (51) est disposé de telle façon que l'au moins un élément de contact (52) électrique soit pressé par la force de rappel de l'élément élastique (51) dans une position de contact électrique pour le prélèvement électrique et/ou dans une position de support mécanique de l'agencement d'éclairage (1),
dans lequel de préférence le dispositif de contact (5) électrique présente au moins deux éléments de contact (52) électriques et dans lequel l'élément élastique (51) est disposé de préférence de telle façon, que les au moins deux éléments de contact (52) électriques soient écartés l'un de l'autre par la force de rappel de l'élément élastique (51) et pressés dans une position de contact électrique pour le prélèvement électrique et/ou dans une position pour le support mécanique et/ou dans lequel l'élément élastique (51) est disposé de préférence entre les deux éléments de contact (52) électriques et/ou
dans lequel de préférence l'au moins un élément de contact (51) électrique, dans un état de non-prélèvement électrique, fait saillie latéralement de la carte de circuit imprimé (4) et/ou
dans lequel de préférence l'au moins un élément de contact (52) électrique est formé comme un connecteur, de préférence comme une tige de contact.

7. Luminaire long (100) selon l'une quelconque des revendications 2 à 6, dans lequel l'agencement d'éclairage (1) présente en outre un dispositif de détachement pour le détachement du prélèvement électrique et/ou du support mécanique de l'agencement d'éclairage (1),
dans lequel le dispositif de détachement est conçu de préférence pour presser l'élément élastique (51) contre la force de rappel de celui-ci, pour ainsi détacher le prélèvement électrique et/ou le support mécanique.

8. Luminaire long (100) selon l'une quelconque des revendications précédentes, dans lequel la face frontale (43) présente un élément optique pour le découplage de lumière de l'agencement d'éclairage (1),
dans lequel de préférence l'élément optique est formé de telle façon que la lumière couplée dans l'élément optique, par exemple de la lumière émise par le moyen d'éclairage (2) et/ou par un moyen d'éclairage adjacent au moyen d'éclairage (2) et/ou à l'agencement d'éclairage (1), soit découplée de l'élément optique essentiellement distribuée sur l'agencement d'éclairage (1) à travers une face avant de la face frontale (43) et/ou
dans lequel de préférence l'élément optique présente un élément guide de lumière, un élément réflecteur et/ou un élément lenticulaire et/ou
dans lequel de préférence l'élément optique est une couverture de l'agencement d'éclairage (1) et/ou
dans lequel de préférence l'élément optique est fabriqué en une matière plastique transparente telle que, par exemple, du polycarbonate.

9. Luminaire long (100) selon l'une quelconque des revendications précédentes,
dans lequel l'appareil d'alimentation (4) est conçu pour fonctionner uniquement avec une tension continue, par exemple fournie par un accumulateur d'énergie, en particulier une batterie et/ou
dans lequel l'appareil d'alimentation (4) est conçu pour fonctionner avec une tension dans la plage de 20 à 60 V, de préférence dans la plage de 24 à 48 V.

10. Luminaire long (100) selon l'une quelconque des revendications précédentes, dans lequel l'appareil d'alimentation (4) présente des composants pour programmer l'agencement d'éclairage, en particulier des composants pour la transmission sans fil de données, par exemple une interface NFC et/ou Bluetooth.

11. Luminaire long (100) selon l'une quelconque des revendications précédentes, dans lequel l'agencement d'éclairage (100) présente un boîtier (6) qui reçoit au moins l'appareil d'alimentation (4) et le moyen d'éclairage (2),
dans lequel le boîtier (6) est formé de préférence pour s'étendre perpendiculairement à l'axe longitudinal du luminaire long (100), lorsque l'agencement d'éclairage (1) dans le luminaire long (100) est prévu pour l'émission de lumière.

12. Luminaire long (100) selon l'une quelconque des revendications précédentes,
dans lequel la carte de circuit imprimé (4), vue perpendiculairement au plan d'extension de la carte de circuit imprimé (4), est formée essentiellement rectangulaire et/ou
dans lequel la carte de circuit imprimé (4), vue parallèlement au plan d'extension de la carte de circuit imprimé (4), est formée avec des parois minces et/ou
dans lequel la carte de circuit imprimé (4) présente une largeur dans la plage de 1 à 5 cm, de préférence dans la plage de 2 à 4 cm, de manière particulièrement préférée dans la plage de 2 à 3 cm et/ou
dans lequel la carte de circuit imprimé (4) est formée comme un dispositif de montage pour le montage de l'agencement d'éclairage (1).

13. Luminaire long (100) selon l'une quelconque des revendications précédentes, dans lequel l'agencement d'éclairage (1) est un éclairage de secours.
